# EUROPEAN PATENT SPECIFICATION

(11) **EP 2 767 783 B1**
(45) Date of publication and mention of the grant of the patent: **27.07.2016**
(21) Application number: 13155414.9
(22) Date of filing: 15.02.2013
(51) Int. Cl.: F25B 15/10, H01L 23/00

(54) **A cooling apparatus**
Kühlvorrichtung
Appareil de refroidissement

(43) Date of publication of application: 20.08.2014
(73) Proprietor: ABB Research Ltd., 8050 Zürich (CH)
(72) Inventor: Agostini, Bruno, 5405 Baden Daetwill (CH); Agostini, Francesco, 5405 Baden Daettwill (CH); Habert, Mathieu, 5405 Baden Daetwill (CH)
(74) Representative: Kolster Oy Ab

(56) References cited:
- US-A- 1 781 541
- US-A1- 2009 178 436

## Description

### BACKGROUND OF THE INVENTION

### FIELD OF THE INVENTION

This invention relates to a cooling apparatus for cooling an electric equipment.

### DESCRIPTION OF PRIOR ART

Previously there are known solutions for cooling an electric equipment by vaporizing a liquid in a cooling element which is used for transferring heat from electric components into a liquid in a fluid channel of the cooling element. Such a cooling apparatus may work with a dual pressure cycle where the saturation temperature difference between the condenser and the evaporator is produced by a system pressure difference.

A drawback with such previously known solutions is the need for an mechanical input to drive a compressor or a pump, which generates the required change in pressure. The need of a compressor or a pump increases the noise level and the costs of the system, while reducing the reliability of the system.

Previously there is also known from US 2009/178436 A1 and US - 1 781 541 A solutions for driving a cooling cycle. However, these solutions require an extra energy source providing heat needed for driving the cooling cycle. The US 2009/178436 A1 discloses a cooling system according to the preamble of claim 1.

### SUMMARY OF THE INVENTION

An object of the present invention is to provide a new solution for cooling an electric equipment, which is simpler, more reliable and cheaper to implement. This object is achieved with the cooling apparatus according to independent claim 1.

### BRIEF DESCRIPTION OF DRAWINGS

In the following the present invention will be described in closer detail by way of example and with reference to the attached drawings, in which
Figure 1 is a block diagram of a first embodiment of a cooling apparatus, and
Figure 2 is a block diagram of a second embodiment of a cooling apparatus.

### DESCRIPTION OF AT LEAST ONE EMBODIMENT

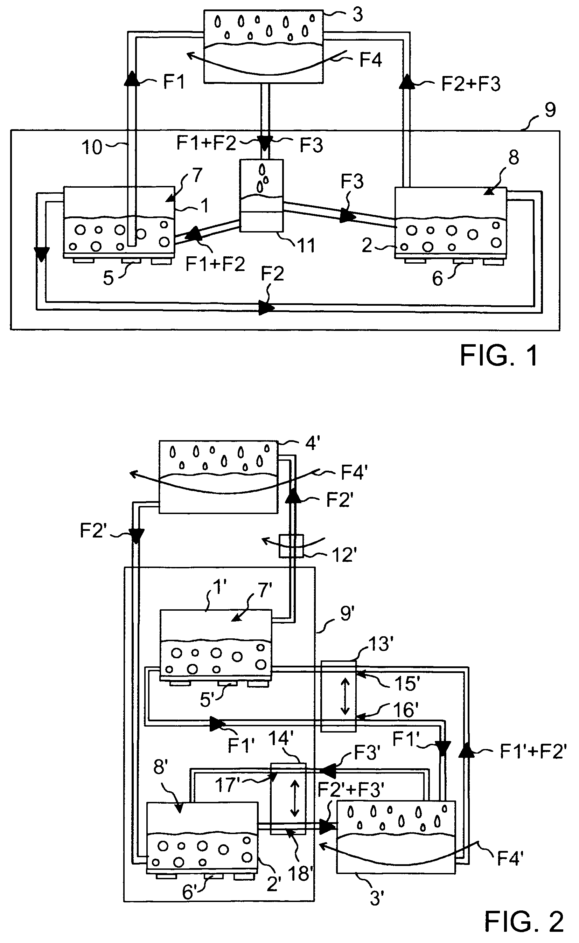

Figure 1 is a block diagram of a first embodiment of a cooling apparatus. The cooling apparatus comprises a generator 1 with first electric components 5. The term "generator" refers to a heat exchanger cooling electric components, and which generates heat into the fluid in the fluid channel of the generator by passing on the heat load from the electric components to the fluid. The cooling apparatus also comprises a evaporator 2 with second electric components 6. The term "evaporator" refers to a heat exchanger cooling electric components by evaporating fluid in the fluid channel of the evaporator with the heat load from the electric components. In the illustrated embodiment it has by way of example been assumed that the first electric components 5 are attached (such as connected with thermal grease, for instance) to the generator 1 and that the second electric components 6 are attached (such as connected with thermal grease, for instance) to the evaporator 2. Consequently, the generator and evaporator may be base plates for accommodating electric components and the fluid channels are arranged into these base plates (or heat sinks). This is, however, not necessary in all embodiments. An alternative is that one or both of the generator and evaporator comprises fins on an outer surface, and that heat is transferred from the respective electric components to the corresponding cooling element by an airflow and the fins, for instance. In any case, heat generated by the first electric components 5 are transferred to a fluid in a flow channel 7 in the generator 1, and correspondingly, heat generated by the second electric components 6 are transferred to a fluid in a flow channel 8 in the evaporator 2.

The first electric components 1 are components with a higher operating temperature than the second electric components 2. The first electric components 1 may include high power electronic devices such as an IGBT (Insulated Gate Bipolar Transistor), a Si/SiC power module (Silicone, Silicone Carbide), a LED (Light Emitting Diode) or other Silicon Carbide electronic components, which typically have a high operating temperature, such as about 125°C at 3kW, for instance. The second electric components 2 may include components with a low operating temperature such as passive electric components like a capacitor, a PCB (Printed Circuit Board) or a surge arrestor, for instance. These components may have an operating temperature of about 65°C at 300W.

The generator 1 and the evaporator 2 are enclosed in a closed compartment 9. The compartment 9 may be an electrical cabinet sealing off electric devices from the surrounding environment, for instance. A high IP class (International Protection) may be required in some applications (such as mining, marine or desert) in order to ensure that dust or moist is efficiently prevented from ending up inside the closed compartment. In order to ensure efficient cooling within such a closed compartment 9, the cooling apparatus comprises a third cooling element 3 receiving heated fluid from within the closed compartment 9. This heat is transferred from the fluid to the outside of the closed compartment 9 by the third cooling element 3. Such transfer may include an airstream passing the third cooling element 3, for instance.

Three fluids having different properties are circulated within the illustrated cooling apparatus. The first fluid can be water, the second fluid ammonia and the third fluid butane, for instance.

The fluid channel 7 of the generator 1 is arranged to receive a first fluid F1 and a second fluid F2 in liquid state. Heat received from the first electric components 5 is transferred to the fluid in the fluid channel 7. Due to this heat the second fluid F2, which evaporates at a lower temperature than the first fluid F1, is evaporated while the first fluid F1 remains in a liquid state. The vaporized second fluid F2 in a gas state exits the flow channel 7 via an outlet illustrated in the upper left corner of the generator 1, and enters the flow channel 8 of the evaporator 2 via a pipe. The first fluid F1 enters the third cooling element 3. One alternative to accomplish this while the first fluid F1 remains in the liquid state is that at least a section 10 of the fluid channel of the generator 1 or of a pipe connecting the fluid channel 7 of the generator 1 with the third cooling element 3 consists of one or more channels having capillary dimensions. In this context "capillary dimension" refers to channels that are capillary-sized, which means that they have a size small enough for bubbles to grow uniquely in a longitudinal direction (in other words in the longitudinal direction of the channel as opposed to the radial direction) and thereby create a so called bubble lift effect by pushing the liquid upwards. The diameter of a channel or tube which is considered capillary depends on the fluid or refrigerant that is used (boiling) inside. The following formula, for instance, can be used to evaluate a suitable diameter: D = (sigma/(g*(rhol-rhov)))^0.5, wherein sigma is the surface tension, g the acceleration of gravity, rhov the vapour density and rhol the liquid density. This formula gives a value around 3 mm for water and ammonia, which are a few examples of the fluids suitable for use as the first fluid in the cooling apparatus. Consequently, the first fluid F1 enters the third cooling element 3 without a need for a pump, for instance.

The fluid channel 8 of the evaporator 2 receives the vaporized second fluid F2 in a gas state and the third fluid F3 in a liquid state. The fluids in the fluid channel 8 are heated with heat from the second electric components 2. Additionally, the second fluid F2 in the gas state reduces a partial pressure of the third fluid F3 in a liquid state and therefore also the temperature required for evaporating the third fluid F3. The second fluid F2 and the third fluid F3, both in a vaporized gas state, exit the evaporator 1 and enter the top of third cooling element 3. This flow is obtained due to a thermosyphon effect without a need to utilize a pump.

In the third cooling element 3 the first F1, second F2 and third F3 fluids come into contact with each other and the fluids are cooled by the third cooling element 3, which transfers heat from the fluids to a medium temperature coolant F4 absorbing the heat from the third cooling element. A suitable coolant may be air, water, Carbon Dioxide CO2, Helium He or Hydrogen H2. Consequently heat is transferred to surroundings outside of the closed compartment 9. For this purpose the third cooling element may have a surface provided with fins, and heat is transferred via the fins to surrounding air, such as into an airflow having a temperature up to 80°C, for instance.

As the first fluid F1 and the second fluid F2 have been selected such that they are miscible, the second fluid F2 in a gas state is absorbed by the first fluid F1 which is in the liquid state. This increases the partial pressure of the third fluid F3 being in the gas state, and which has been selected such that it is sparingly miscible or not miscible with the first F1 or second F2 fluid. Consequently, the fluid F3 is condensed in the third cooling element 3.

The mixture of the first F1 and second F2 fluids and the third fluid F3, all in liquid state, are introduced into a separator 11, which in the illustrated example is located within the closed compartment 9. Due to differences in the density of the mixture of the first F1 and second F2 fluids as compared to the third fluid F3, the separator is able to separate these fluids, such that the mixture of the first F1 and second F2 fluid is forwarded to the flow channel 7 of the generator 1 and the third fluid is forwarded to the flow channel 8 of the evaporator 2.

Circulation of the fluids through the cooling apparatus can, as is clear from the above example, be accomplished without the use of any pumps in the illustrated single pressure absorption refrigeration system. The energy needed to drive the absorption cycle and the entire cooling process is mainly obtained from the first electric components cooled by the generator. Additionally evaporation of fluid in the evaporator 2 can be obtained even though the heat load from the second electric components 6 may not be sufficient alone to cause such evaporation. Consequently adequate cooling can be obtained also for the second electric components 6.

In order to ensure efficient circulation of the fluids in all situations the following relations should apply:

T1 >T3>T2, where T1 is the operating temperature of the first electric components 1, T3 is the temperature of the coolant cooling the third cooling element 3, and T2 is the temperature of the second electric components 2,

P3=P1+P2, where P3 is the heat load (power) transferred from the third cooling element 3 via the coolant to the outside of the apparatus, P1 is the heat load generated by the first electric components 5, and P2 is the heat load generated by the second electric components 6, and

P2<<P1 (typically about 10 times smaller), where P1 is the heat load generated by the first electric components 5, and P2 is the heat load generated by the second electric components 6.

Figure 2 is a block diagram of a second embodiment of a cooling apparatus. The cooling apparatus of Figure 2 is very similar to the one described in connection with Figure 1. In the following the embodiment of Figure 2 will be described mainly by pointing out the differences between these embodiments.

In Figure 2 the cooling apparatus comprises a fourth cooling element 4' arranged outside of the closed compartment 9' for receiving heated fluid and for transferring heat from the heated fluid to the outside of the closed compartment 9' via a suitable coolant F4', such as air, water, Carbon Dioxide CO2, Helium He or Hydrogen H2.

Also the embodiment of Figure 2 utilizes three different fluids having different properties. Suitable combinations of fluids are:
- water, NH3 and He (or H2)
- R134a (1,1,1,2-Tetrafluoroethane), DMAC (Dimethylacetamide) and He (or H2),
- R124 (1-Chloro-1,2,2,2-Tetrafluorethane), DMAC (Dimethylacetamide) and He (or H2),
- R134a (1,1,1,2-Tetrafluoroethane), DMETEG (DiMethyl Ether Tetra Ethylene Glycol) and He (or H2).

The fluid channel 7' of the generator 1' is arranged to receive a first fluid F1' and a second fluid F2' in a liquid state and to heat the received liquids with heat received from the first electric components 1'. Due to this, the second fluid F2' is vaporized and forwarded to the fourth cooling 4' element in a gas state. In the illustrated embodiment a rectifier 12' is arranged between the generator 1' and the fourth cooling element 4' to condense back to the generator 1' any parts of the first fluid F1' to prevent the first fluid F1' from reaching (and lowering the performance of) the fourth cooling element 4'. The rectifier may be implemented as a simple vertical tube exposed to outside air, and which possibly is provided with fins. The first fluid F1' remaining in a liquid state is forwarded from the generator 1' to the third cooling element 3'.

The third cooling element 3' receives the first fluid F1' in a liquid state from the generator 1' and the second F2' and third F3' fluid in a vaporized gas state from the evaporator 2'. In the third cooling element 3' the first F1', second F2' and third F3' fluids come into contact with each other and the fluids are cooled by the third cooling element 3, which transfers heat from the fluids to a medium temperature coolant F4' absorbing the heat from the third cooling element. A suitable coolant may be air, water, Carbond Dioxide CO2, Helium He or Hydrogen H2. Consequently heat is transferred to surroundings outside of the closed compartment 9'. For this purpose the third cooling element may have a surface provided with fins, and heat is transferred via the fins to surrounding air, such as into an airflow, for instance.

As the first fluid F1' and the second fluid F2' have been selected such that they are miscible, the second fluid F2' in a gas state is absorbed by the first fluid F1' which is in the liquid state. The mix of the first F1' and second F2' fluid is provided to the generator 1' from the third cooling element 3'. The third fluid F3' which has been selected to be sparingly miscible or not miscible with the first F1' and second fluid F2', is returned from the third cooling element 3' to the evaporator 2' in a vaporized gas state.

The fourth cooling element 4' receives the vaporized second fluid F2' in a gas state from the generator 1'. In the fourth cooling element 4' the second fluid F2' is cooled such that it condensates, after which it is forwarded to the evaporator 2' in a liquid state.

The fluid channel 8' of the evaporator 2' receives the second fluid F2' in a liquid state and the third fluid F3' in a gas state. The fluids in the fluid channel 8' are heated with heat from the second electric components 2'. Additionally, the third fluid F3' in the gas state reduces a partial pressure of the second fluid F2' in a liquid state and therefore also the temperature required for evaporating the second fluid F2'. Therefore the second fluid F2' is evaporated in the evaporator 2'. The second fluid F2' and the third fluid F3', both in a vaporized gas state, exit the evaporator 2' and enter the third cooling element 3'.

In the illustrated example the cooling apparatus of Figure 2 additionally comprises a first 13' and a second heat 14' exchanger. These heat exchangers are not necessary in all implementations, however, one or more heat exchanger can be utilized in some implementations in order increase the overall performance of the system.

The first heat exchanger 13' has a first fluid channel 15' for passing the first F1' and second fluids F2' from the third cooling element 3' to the generator 1', and a second fluid channel 16' for passing the first fluid F1' from the generator 1' to the third cooling element 3'. Due to the first heat exchanger the first fluid F1' from the generator 1' is pre-cooled before entering the third cooling element 3'.

The second heat exchanger 14' with a first fluid channel 17' for passing the third fluid F3' from the third cooling element 3' to the evaporator 2', and a second fluid channel 18' for passing the second F2' and third F3' fluid from the evaporator 2' to the third cooling element 3'. Due to the second heat exchanger the second F2' and third F3' fluids are pre-cooled before entering the third cooling element 3'.

As in the previous embodiment, circulation of the fluids through the cooling apparatus can be accomplished without the use of any pumps in the illustrated single pressure absorption refrigeration system. The energy needed to drive the absorption cycle and the entire cooling process is mainly obtained from the first electric components cooled by the generator. Additionally evaporation of fluid in the evaporator 2' can be obtained even though the heat load from the second electric components 6' may not be sufficient alone to cause such evaporation. Consequently adequate cooling can be obtained also for the second electric components 6'.

In order to ensure efficient circulation of the fluids in all situations the following relations should apply:

T1 >T3>T2, where T1 is the operating temperature of the first electric components 1', T3 is the temperature of the coolant cooling the fourth cooling element 4' (the temperature of the coolant cooling the third cooling element should also be approximately T3), and T2 is the temperature of the second electric components 2',

P4+P3+PR=P1+P2, where P3 and P4, respectively are the heat loads (power) transferred from the third 3' respective fourth 4' cooling elements via the coolant F4' to the outside of the apparatus, P1 is the heat load generated by the first electric components 5', P2 is the heat load generated by the second electric components 6', and PR the heat exchanged in the rectifier 12'.

P2<<P1 (typically about 5 to 10 times smaller), where P1 is the heat load generated by the first electric components 5', and P2 is the heat load generated by the second electric components 6'.

It is to be understood that the above description and the accompanying figures are only intended to illustrate the present invention. It will be obvious to a person skilled in the art that the invention can be varied and modified without departing from the scope of the invention.

## Claims

1. A cooling apparatus for an electric equipment comprising:
first electric components (5, 5')
second electric components (6, 6'),
an evaporator as a second cooling element (2, 2') for receiving a heat load from the second electric components (6, 6'), the evaporator comprising a fluid channel (8, 8') for transferring heat received from the second electric components (6, 6') into the fluid channel, the fluid channel (8, 8') of the evaporator (2, 2') is arranged to receive a fluid (F3, F2') in a liquid state and a fluid (F2, F3') in a gas state, whereby the fluid (F2, F3') in the gas state reduces a partial pressure of the fluid in a liquid state and the temperature required for evaporating the fluid in the liquid state, such that the fluid (F3, F2') in the liquid state is evaporated, and
a closed compartment (9, 9') enclosing the evaporator and the second electric components (6, 6'), **characterized in that** the apparatus additionally comprises:
a generator as a first cooling element (1,1') receiving a heat load from the first electric components (5, 5') having a higher operating temperature than the second electric components, the generator comprising a fluid channel (7, 7') for receiving liquid and for evaporating a part of the received liquid with the heat load from the first electric components (5, 5'), the generator and the first electric components (5, 5') are enclosed in the closed compartment (9, 9'), and
a third cooling element (3, 3') arranged outside of the closed compartment for receiving heated fluid from at least one of the generator and evaporator (1, 2, 1', 2') and for transferring heat from the heated fluid to the outside of the closed compartment (9, 9').

2. A cooling apparatus according to claim 1, **characterized in that** the first electric components (5, 5') include power electronic devices generating a higher heat load than the second electric components (6, 6') which include passive electric components.

3. A cooling apparatus according to one of claims 1 to 2, **characterized in that** the cooling apparatus contains three different fluids, a first and a second fluid (F1, F2, F1', F2') which are miscible, and a third fluid (F3, F3') which is sparingly miscible or not miscible with the first or second fluid.

4. A cooling apparatus according to one of claims 1 to 3, **characterized in that**
the fluid channel (7) of the generator (1) is arranged to receive a first fluid (F1) and a second (F2) fluid in liquid state, to heat the received liquids with heat received from the first electric components (5), to provide the third cooling element (3) with the first fluid (F1) in a liquid state, and to provide the fluid channel (8) of the evaporator (2) with the vaporized second fluid (F2) in a gas state,
the fluid channel (8) of the evaporator (2) is arranged to receive the vaporized second fluid (F2) in a gas state from the generator (1) and to receive a third fluid (F3) in a liquid state, to heat the received fluids with heat from the second electric components (6) and to provide the third cooling element (3) with the vaporized second (F2) and third (F3) fluids in a gas state, and
the third cooling element (3) is arranged to receive the first fluid (F1) in a liquid state from the generator (1) and the vaporized second and third fluids (F2, F3) in a gas state from the evaporator (2), to absorb the vaporized second fluid (F2) by the first fluid (F1) in a liquid state in order to obtain a liquid of the miscible first and second fluids (F1, F2) and to condense the third fluid (F3), which is sparingly miscible or not miscible with the first fluid (F1), into a liquid while transferring heat from the fluids to the outside of the closed compartment (9), and to provide the generator (1) via a separator (11) with the first and second fluids (F1, F2) in a liquid state and the evaporator (2) with the third fluid (F3) in a liquid state.

5. A cooling apparatus according to claim 4, **characterized in that** at least a section of the fluid channel (7) of the generator (1) or of a pipe (10) connecting the fluid channel (7) of the generator (1) with the third cooling element (3) consists of one or more channels having a capillary dimension.

6. A cooling apparatus according to one of claims 1 to 3, **characterized in that**
the cooling apparatus comprises a fourth cooling element (4') arranged outside of the closed compartment (9') for receiving heated fluid and for transferring heat from the heated fluid to the outside of the closed compartment (9'),
the fluid channel (7') of the generator (1') is arranged to receive a first fluid (F1') and a second fluid (F2') in a liquid state, to heat the received liquids with heat received from the first electric components (1'), to provide the fourth cooling element (4') with the vaporized second fluid (F2') in a gas state, and to provide the third cooling element (3') with the first fluid (F1') in a liquid state,
the third cooling element (3') is arranged to receive the first fluid (F1') in a liquid state from the generator (1'), the second fluid (F2') and a third fluid (F3') in a vaporized gas state from the evaporator (2'), to absorb the vaporized second fluid (F2') by the first fluid (F1') in a liquid state in order to obtain a liquid of the miscible first and second fluids while transferring heat from the fluids to the outside of the closed compartment (9'), to provide the fluid channel (7') of the generator (1') with the first and second fluids (F1' , F2') in a liquid state, and to provide the evaporator (2') with the third fluid (F3'), which is sparingly miscible or not miscible with the first (F1') and second fluid (F2'), in a vaporized gas state, and
the fourth cooling element (4') is arranged to receive the vaporized second fluid (F2') in a gas state from the generator (1'), to condense the second fluid (F2'), and to provide the second fluid (F2') in a liquid state to the evaporator (2').

7. A cooling apparatus according to claim 6, **characterized in that** the cooling apparatus comprises:
a first heat exchanger (13') with a first fluid channel (15') for passing the first (F1') and second (F2') fluids from the third cooling element (3') to the generator (1'), and with a second fluid channel (16') for passing the first fluid (F1') from the generator (1') to the third cooling element (3').

8. A cooling apparatus according to claim 6 or 7, **characterized in that** the cooling apparatus comprises:
a second heat exchanger (14') with a first fluid channel (17') for passing the third fluid (F3') from the third cooling element (3') to the evaporator (2'), and with a second fluid channel (18') for passing the second (F2') and third fluid (F3') from the evaporator (2') to the third cooling element (3').

## Patentansprüche

1. Kühlvorrichtung für eine elektrische Ausrüstung, wobei die Vorrichtung umfasst:
erste elektrische Komponenten (5, 5'),
zweite elektrische Komponenten (6, 6'),
einen Verdampfer als ein zweites Kühlelement (2, 2'), um eine Wärmelast von den zweiten elektrischen Komponenten (6, 6') aufzunehmen, wobei der Verdampfer einen Fluidkanal (8, 8') umfasst, um Wärme, die von den zweiten elektrischen Komponenten (6, 6') aufgenommen wird, an den Fluidkanal zu übertragen, wobei der Fluidkanal (8, 8') des Verdampfers (2, 2') angeordnet ist, um ein Fluid (F3, F2') in einem flüssigen Zustand und ein Fluid (F2, F3') in einem gasförmigen Zustand aufzunehmen, wobei das Fluid (F2, F3') in dem gasförmigen Zustand einen Partialdruck des Fluids in einem flüssigen Zustand und die Temperatur, die erforderlich ist, um das Fluid in dem flüssigen Zustand zu verdampfen, derart verringert, dass das Fluid (F3, F2') in dem flüssigen Zustand verdampft wird, und
eine geschlossene Kammer (9, 9'), die den Verdampfer und die zweiten elektrischen Komponenten (6, 6') umschließt, **dadurch gekennzeichnet, dass** die Vorrichtung zusätzlich umfasst:
einen Generator als ein erstes Kühlelement (1, 1'), um eine Wärmelast von den ersten elektrischen Komponenten (5, 5'), die eine höhere Betriebstemperatur als die zweiten elektrischen Komponenten aufweisen, aufzunehmen, wobei der Generator einen Fluidkanal (7, 7') umfasst, um Flüssigkeit aufzunehmen und um einen Teil der aufgenommenen Flüssigkeit mit der Wärmelast von den ersten elektrischen Komponenten (5, 5') zu verdampfen, wobei der Generator und die ersten elektrischen Komponenten (5, 5') in der geschlossenen Kammer (9, 9') umschlossen sind, und
ein drittes Kühlelement (3, 3'), das außerhalb der geschlossenen Kammer angeordnet ist, um von dem Generator und/oder von dem Verdampfer (1, 2, 1', 2') erwärmtes Fluid aufzunehmen und um Wärme von dem erwärmten Fluid an die Außenumgebung der geschlossenen Kammer (9, 9') zu übertragen.

2. Kühlvorrichtung nach Anspruch 1, **dadurch gekennzeichnet, dass** die ersten elektrischen Komponenten (5, 5') Vorrichtungen der Leistungselektronik enthalten, die eine höhere Wärmelast als die zweiten elektrischen Komponenten (6, 6') erzeugen, die passive elektrische Komponenten enthalten.

3. Kühlvorrichtung nach einem der Ansprüche 1 bis 2, **dadurch gekennzeichnet, dass** die Kühlvorrichtung drei verschiedene Fluide enthält, ein erstes und ein zweites Fluid (F1, F2, F1', F2'), die mischbar sind, und ein drittes Fluid (F3, F3'), das mit dem ersten oder mit dem zweiten Fluid schwer oder gar nicht mischbar ist.

4. Kühlvorrichtung nach einem der Ansprüche 1 bis 3, **dadurch gekennzeichnet, dass**
der Fluidkanal (7) des Generators (1) angeordnet ist, um ein erstes Fluid (F1) und ein zweites Fluid (F2) in einem flüssigen Zustand zu empfangen, um die empfangenen Flüssigkeiten mit Wärme, die von den ersten elektrischen Komponenten (5) empfangen wird, zu erwärmen, um das dritte Kühlelement (3) mit dem ersten Fluid (F1) in einem flüssigen Zustand zu versorgen, und um den Fluidkanal (8) des Verdampfers (2) mit dem verdampften zweiten Fluid (F2) in einem gasförmigen Zustand zu versorgen,
der Fluidkanal (8) des Verdampfers (2) angeordnet ist, um das verdampfte zweite Fluid (F2) in einem gasförmigen Zustand von dem Generator (1) zu empfangen und um ein drittes Fluid (F3) in einem flüssigen Zustand zu empfangen, um die empfangenen Fluide mit Wärme von den zweiten elektrischen Komponenten (6) zu erwärmen, und um das dritte Kühlelement (3) mit dem verdampften zweiten (F2) und dem dritten (F3) Fluid in einem gasförmigen Zustand zu versorgen, und
das dritte Kühlelement (3) angeordnet ist, um das erste Fluid (F1) in einem flüssigen Zustand von dem Generator (1) und das verdampfte zweite und dritte Fluid (F2, F3) in einem gasförmigen Zustand von dem Verdampfer (2) zu empfangen, um das verdampfte zweite Fluid (F2) durch das erste Fluid (F1) in einem flüssigen Zustand zu absorbieren, um eine Flüssigkeit des mischbaren ersten und zweiten Fluids (F1, F2) zu erhalten und um das dritte Fluid (F3), das mit dem ersten oder mit dem zweiten Fluid (F1) schwer oder gar nicht mischbar ist, in einer Flüssigkeit zu kondensieren, während Wärme von den Fluiden an die Außenumgebung der geschlossenen Kammer (9) übertragen wird, und um den Generator (1) über eine Trenneinrichtung (11) mit dem ersten und zweiten Fluid (F1, F2) in einem flüssigen Zustand und den Verdampfer (2) mit dem dritten Fluid (F3) in einem flüssigen Zustand zu versorgen.

5. Kühlvorrichtung nach Anspruch 4, **dadurch gekennzeichnet, dass** mindestens ein Abschnitt des Fluidkanals (7) des Generators (1) oder eines Rohrs (10), das den Fluidkanal (7) des Generators (1) mit dem dritten Kühlelement (3) verbindet, aus einem oder mehreren Kanälen mit einer Kapillardimension besteht.

6. Kühlvorrichtung nach einem der Ansprüche 1 bis 3, **dadurch gekennzeichnet, dass**
die Kühlvorrichtung ein viertes Kühlelement (4') umfasst, das außerhalb der geschlossenen Kammer (9') angeordnet ist, um erwärmtes Fluid aufzunehmen und um Wärme von dem erwärmten Fluid an die Außenumgebung der geschlossenen Kammer (9') zu übertragen,
der Fluidkanal (7') des Generators (1') angeordnet ist, um ein erstes Fluid (F1') und ein zweites Fluid (F2') in einem flüssigen Zustand zu empfangen, um die empfangenen Flüssigkeiten mit Wärme, die von den ersten elektrischen Komponenten (1') empfangen wird, zu erwärmen, um das vierte Kühlelement (4') mit dem verdampften zweiten Fluid (F2') in einem gasförmigen Zustand zu versorgen, und um das dritte Kühlelement (3') mit dem ersten Fluid (F1') in einem flüssigen Zustand zu versorgen,
das dritte Kühlelement (3') angeordnet ist, um das erste Fluid (F1') in einem flüssigen Zustand von dem Generator (1') zu empfangen, das zweite Fluid (F2') und ein drittes Fluid (F3') in einem verdampften gasförmigen Zustand von dem Verdampfer (2') zu empfangen, um das verdampfte zweite Fluid (F2') durch das erste Fluid (F1') in einem flüssigen Zustand zu absorbieren, um eine Flüssigkeit des mischbaren ersten und zweiten Fluids zu erhalten, während Wärme von den Fluiden an die Außenumgebung der geschlossenen Kammer (9') übertragen wird, um den Fluidkanal (7') des Generators (1') mit dem ersten und dem zweiten Fluid (F1', F2') in einem flüssigen Zustand zu versorgen, und um den Verdampfer (2') mit dem dritten Fluid (F3'), das mit dem ersten (F1') und mit dem zweiten Fluid (F2') schwer oder gar nicht mischbar ist, in einem verdampften gasförmigen Zustand zu versorgen, und
das vierte Kühlelement (4') angeordnet ist, um das verdampfte zweite Fluid (F2') in einem gasförmigen Zustand von dem Generator (1') zu empfangen, um das zweite Fluid (F2') zu kondensieren und um das zweite Fluid (F2') in einem flüssigen Zustand dem Verdampfer (2') bereitzustellen.

7. Kühlvorrichtung nach Anspruch 6, **dadurch gekennzeichnet, dass** die Kühlvorrichtung umfasst:
einen ersten Wärmetauscher (13') mit einem ersten Fluidkanal (15'), um das erste Fluid (F1') und das zweite (F2') Fluid von dem dritten Kühlelement (3') zu dem Generator (1') durchzuleiten, und mit einem zweiten Fluidkanal (16'), um das erste Fluid (F1') von dem Generator (1') zu dem dritten Kühlelement (3') durchzuleiten.

8. Kühlvorrichtung nach einem der Ansprüche 6 oder 7, **dadurch gekennzeichnet, dass** die Kühlvorrichtung umfasst:
einen zweiten Wärmetauscher (14') mit einem ersten Fluidkanal (17'), um das dritte Fluid (F3') von dem dritten Kühlelement (3') zu dem Verdampfer (2') durchzuleiten, und mit einem zweiten Fluidkanal (18'), um das zweite Fluid (F2') und das dritte Fluid (F3') von dem Verdampfer (2') zu dem dritten Kühlelement (3') durchzuleiten.

## Revendications

1. Appareil de refroidissement pour un équipement
électrique, comprenant :
des premiers composants électriques (5, 5'),
des deuxièmes composants électriques (6, 6'),
un évaporateur comme deuxième élément de refroidissement (2, 2') pour recevoir une charge de chaleur des deuxièmes composants électriques (6, 6'), l'évaporateur comprenant un canal de fluide (8, 8') pour transférer de la chaleur reçue des deuxièmes composants électriques (6, 6') dans le canal de fluide, le canal de fluide (8, 8') de l'évaporateur (2, 2') étant aménagé pour recevoir un fluide (F3, F2') à l'état liquide et un fluide (F2, F3') à l'état gazeux, dans lequel le fluide (F2, F3') à l'état gazeux réduit une pression partielle du fluide à l'état liquide et la température nécessaire pour évaporer le fluide à l'état liquide de sorte que le fluide (F3, F2') à l'état liquide soit évaporé, et
un compartiment fermé (9, 9') enserrant l'évaporateur et les deuxièmes composants électriques (6, 6'), **caractérisé en ce que** l'appareil comprend en outre :
un générateur comme premier élément de refroidissement (1, 1') recevant une charge de chaleur des premiers composants électriques (5, 5') ayant une température de fonctionnement plus élevée que celle des deuxièmes composants électriques, le générateur comprenant un canal de fluide (7, 7') pour recevoir du liquide et évaporer une partie du liquide reçu avec la charge de chaleur provenant des premiers composants électriques (5, 5'), le générateur et les premiers composants électriques (5, 5') étant enserrés dans le compartiment fermé (9,9'), et
un troisième élément de refroidissement (3, 3') aménagé à l'extérieur du compartiment fermé pour recevoir du fluide chauffé d'au moins l'un du générateur et de l'évaporateur (1, 2, 1', 2') et transférer de la chaleur du fluide chauffé à l'extérieur du compartiment fermé (9, 9').

2. Appareil de refroidissement selon la revendication 1, **caractérisé en ce que** les premiers composants électriques (5, 5') comprennent des dispositifs électroniques moteurs générant une charge de chaleur plus élevée que celle des deuxièmes composants électriques (6, 6') qui comprennent des composants électriques passifs.

3. Appareil de refroidissement selon l'une des revendications 1 à 2, **caractérisé en ce que** l'appareil de refroidissement comprend trois fluides différents, un premier et un deuxième fluide (F1, F2, F1', F2') qui sont miscibles et un troisième fluide (F3, F3') qui est peu miscible ou pas miscible avec le premier ou le deuxième fluide.

4. Appareil de refroidissement selon l'une des revendications 1 à 3, **caractérisé en ce que** :
le canal de fluide (7) du générateur (1) est aménagé pour recevoir un premier fluide (F1) et un deuxième fluide (F2) à l'état liquide, chauffer les liquides reçus avec de la chaleur reçue des premiers composants électriques (5), fournir au troisième élément de refroidissement (3) le premier fluide (F1) à l'état liquide et fournir au canal de fluide (8) de l'évaporateur (2) le deuxième fluide vaporisé (F2) à l'état gazeux,
le canal de fluide (8) de l'évaporateur (2) est aménagé pour recevoir le deuxième fluide vaporisé (F2) à l'état gazeux du générateur (1) et recevoir un troisième fluide (F3) à l'état liquide, chauffer les fluides reçus avec de la chaleur provenant des deuxièmes composants électriques (6) et fournir au troisième élément de refroidissement (3) le deuxième (F2) et le troisième (F3) fluide vaporisés à l'état gazeux, et
le troisième élément de refroidissement (3) est aménagé pour recevoir le premier fluide (F1) à l'état liquide du générateur (1) et les deuxième et troisième fluides vaporisés (F2, F3) à l'état gazeux de l'évaporateur (2), absorber le deuxième fluide vaporisé (F2) par le premier fluide (F1) à l'état liquide afin d'obtenir un liquide des premier et deuxième fluides miscibles (F1, F2) et condenser le troisième fluide (F3) qui est peu miscible ou pas miscible avec le premier fluide (F1) en un liquide tout en transférant de la chaleur des fluides à l'extérieur du compartiment fermé (9) et fournir au générateur (1) via un séparateur (11) les premier et deuxième fluides (F1, F2) à l'état liquide et à l'évaporateur (2) le troisième fluide (F3) à l'état liquide.

5. Appareil de refroidissement selon la revendication 4, **caractérisé en ce qu'**au moins une section du canal de fluide (7) du générateur (1) ou d'un tuyau (10) raccordant le canal de fluide (7) du générateur (1) au troisième élément de refroidissement (3) est constituée d'un ou plusieurs canaux ayant une dimension capillaire.

6. Appareil de refroidissement selon l'une des
revendications 1 à 3, **caractérisé en ce que** :
l'appareil de refroidissement comprend un quatrième élément de refroidissement (4') aménagé à l'extérieur du compartiment fermé (9') pour recevoir du fluide chauffé et transférer de la chaleur du fluide chauffé à l'extérieur du compartiment fermé (9'),
le canal de fluide (7') du générateur (1') est aménagé pour recevoir un premier fluide (F1') et un deuxième fluide (F2') à l'état liquide, chauffer les liquides reçus avec de la chaleur reçue des premiers composants électriques (1'), fournir au quatrième élément de refroidissement (4') le deuxième fluide vaporisé (F2') à l'état gazeux et fournir au troisième élément de refroidissement (3') le premier fluide (F1') à l'état liquide,
le troisième élément de refroidissement (3') est aménagé pour recevoir le premier fluide (F1') à l'état liquide du générateur (1'), le deuxième fluide (F2') et un troisième fluide (F3') à l'état gazeux vaporisé de l'évaporateur (2'), absorber le deuxième fluide vaporisé (F2') par le premier fluide (F1') à l'état liquide afin d'obtenir un liquide des premier et deuxième fluides miscibles tout en transférant de la chaleur des fluides à l'extérieur du compartiment fermé (9'), fournir au canal de fluide (7') du générateur (1') les premier et deuxième fluides (F1', F2') à l'état liquide et fournir à l'évaporateur (2') le troisième fluide (F3'), qui est peu miscible ou pas miscible avec le premier (F1') et le deuxième fluide (F2') à l'état gazeux vaporisé, et
le quatrième élément de refroidissement (4') est aménagé pour recevoir le deuxième fluide vaporisé (F2') à l'état gazeux du générateur (1'), condenser le deuxième fluide (F2') et fournir le deuxième fluide (F2') à l'état liquide à l'évaporateur (2').

7. Appareil de refroidissement selon la revendication 6, **caractérisé en ce que** l'appareil de refroidissement comprend :
un premier échangeur de chaleur (13') avec un premier canal de fluide (15') pour faire passer les premier (F1') et deuxième (F2') fluides du troisième élément de refroidissement (3') au générateur (1') et avec un second canal de fluide (16') pour faire passer le premier fluide (F1') du générateur (1') au troisième élément de refroidissement (3').

8. Appareil de refroidissement selon la revendication 6 ou la revendication 7, **caractérisé en ce que** l'appareil de refroidissement comprend :
un second échangeur de chaleur (14') avec un premier canal de fluide (17') pour faire passer le troisième fluide (F3') du troisième élément de refroidissement (3') à l'évaporateur (2') et avec un second canal de fluide (18') pour faire passer le deuxième (F2') et le troisième (F3') fluide de l'évaporateur (2') au troisième élément de refroidissement (3').
